# EUROPEAN PATENT APPLICATION

(11) **EP 4 708 689 A1**
(43) Date of publication of application: **11.03.2026**
(21) Application number: 25195301.4
(22) Date of filing: 12.08.2025
(51) Int. Cl.: H03H 9/54, H03H 9/56, H03H 9/60, H03H 9/64

(54) **RECONFIGURABLE FILTERS IN A MULTIPLEXER**

(30) Priority: 29.08.2024 US 202418819868
(71) Applicant: Avago Technologies International Sales Pte. Limited, Singapore 768923 (SG)
(72) Inventor: Kim, Jeesu, San Ramon, CA, 94582 (US); Shin, JeaShik, Hwaseong-si, Gyeonggi-do (KR); Yoon, YongHoon, Seoul (KR)
(74) Representative: Grünecker Patent- und Rechtsanwälte PartG mbB

(57) **Abstract**

An example filter for radio frequency signals in a radio includes first resonators (202₁, 202₂, 202₃, 202₄) coupled in series between an input (IN) and an output (OUT); a second resonator (204₁, 204₂, 204₃, 204₄) coupled as a shunt between a node in the series and a reference voltage; and a first circuit coupled in parallel with one of the first resonators or coupled in series with one of the second resonators, the first circuit including a switch (210, 404) coupled in series with an impedance (210, 410).

## Description

### BACKGROUND

A wireless communication device can comply with various standards. For example, a device can comply with multiple Long-Term Evolution (LTE) standards, multiple Wi-Fi standards, and the like (e.g., a smartphone device). The different standards can specify different frequency bands for propagation of radio frequency (RF) signals. A device can include a multi-band system where a received RF signal is separated, combined, blocked, and routed by different RF filters. An RF filter (referred to herein as a filter) may be a circuit that allows some RF signals to pass while suppressing other RF signals based on frequency thereof. Each filter can support one band having a specific frequency range (e.g., one filter per LTE standard, one filter per Wi-Fi standard, etc.).

A wireless communication device can support an increasing number of frequency bands used in modern communication systems, which can cause the device to include an increasing number of filters. Increasing the number of supported frequency bands, however, can require larger device sizes to accommodate the additional filters and the additional support circuitry. The additional filters and support circuitry can also increase cost of the devices.

### SUMMARY

In an embodiment, a filter for radio frequency (RF) signals in a radio is described. The filter includes first resonators coupled in series between an input and an output, a second resonator coupled as a shunt between a node in the series and a reference voltage, a first circuit coupled in parallel with one of the first resonators. The first circuit includes a switch coupled in series with an impedance.

In another embodiment, a filter for RF signals in a radio is described. The filter includes first resonators coupled in series between an input and an output, a second resonator coupled as a shunt between a node in the series and a reference voltage, a first circuit coupled between the second resonator and the reference voltage. The second circuit includes a first impedance in parallel with a series combination of a second impedance and a switch.

In another embodiment, an apparatus is described. The apparatus includes an antenna, a receiver path and a transmitter path coupled to the antenna, and a filter disposed in the receiver path or the transmitter path. The filter includes first resonators coupled in series between an input and an output, a second resonator coupled as a shunt between a node in the series and a reference voltage; and at least one of: (1) a first circuit coupled in parallel with one of the first resonators, the first circuit including a first switch coupled in series with first impedance; and (2) a second circuit coupled between the second resonator and the reference voltage, the second circuit including a second impedance in parallel with a series combination of a third impedance and a second switch.

### BRIEF DESCRIPTION OF THE DRAWINGS

Fig. 1A is a block diagram depicting a radio according to some embodiments.
Fig. 1B is a block diagram depicting another view of radio according to some embodiments.
Fig. 2 is a schematic diagram depicting a reconfigurable filter according to some embodiments.
Fig. 3A is a graph depicting spectrum characteristics of the reconfigurable filter of Fig. 2 in a first configuration.
Fig. 3B is a graph depicting spectrum characteristics of the reconfigurable filter of Fig. 2 in a second configuration.
Fig. 4 is a schematic diagram depicting a reconfigurable filter 400 according to further embodiments.
Fig. 5 is a graph depicting spectrum characteristics of the reconfigurable filter of Fig. 4.
Fig. 6 is a schematic diagram depicting a reconfigurable filter according to further embodiments.
Fig. 7 is a graph depicting spectrum characteristics of reconfigurable filter of Fig. 6.

### DETAILED DESCRIPTION

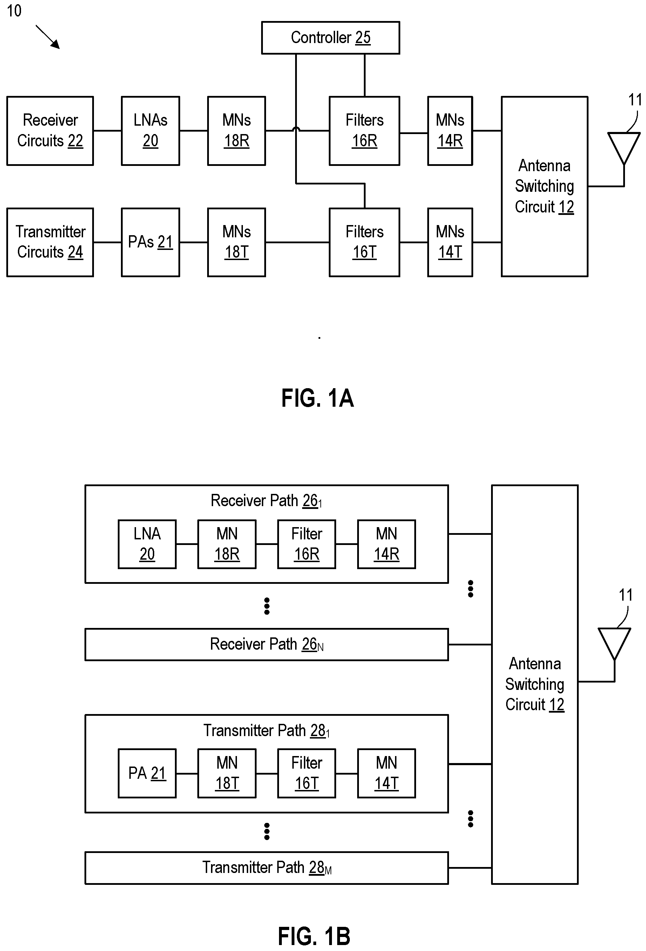

Fig. 1A is a block diagram depicting a radio 10 according to some embodiments. Radio 10 may be included in any type of wireless communication device known in the art. A radio may be a transceiver that includes a receiver or receiving RF signals and a transmitter for transmitting RF signals. An RF signal may be an electromagnetic signal having a frequency in the RF spectrum (e.g., between 20 kHz to 300 GHz). Radio 10 can include an antenna 11, an antenna switching circuit 12, matching networks (MNs) 14R, MNs 14T, filters 16R, filters 16T, MNs 18R, MNs 18T, low-noise amplifiers (LNAs) 20R, power amplifiers (PAs) 20T, receiver circuits 22, and transmitter circuits 24. Transmitter circuits 24 may be circuits that process data to be transmitted into an RF signal. Receiver circuits 22 may be circuits that process an RF signal to receive data. A PA may be a circuit that amplifies power of an RF signal. PAs 21 can amplify RF signals generated by transmitter circuits 23. A LNA may be a circuit that amplifies an RF signal without significantly degrading its signal-to-noise ratio (SNR). LNAs 20 can amplify RF signals supplied to receiver circuits 22.

A MN may be a circuit that matches impedance between a source and a load. Mismatched impedance can lead to power loss, signal reflection, and reduced efficiency. An MN can ensure that a maximum amount of power is transferred between components of a device. Radio 10 can include MNs 18R disposed between LNAs 20 and filters 16R, MNs 14R disposed between filters 16R and antenna switching circuit 12, MNs 18T disposed between PAs 21 and filters 16T, and MNs 14T disposed between filters 16T and antenna switch circuit 12. MNs 14R can be configured to transfer maximum power from antenna 11 to filters 16R. MNs 14T can be configured to transfer maximum power from filters 16T to antenna 11. MNs 18R can be configured to transfer maximum power from filters 16R to LNAs 20. MNs 18T can be configured to transfer maximum power from PAs 21 to filters 16T.

Each of filters 16R can be an RF filter for a particular frequency band. Filters 16R can include different filters for different frequency bands. Likewise, each of filters 16T can be an RF filter for a particular frequency band. Filters 16T can include different filters for different frequency bands. In embodiments, one or more of filters 16R can be a reconfigurable filter as described further herein. In embodiments, one or more of filters 16T can be a reconfigurable filter as described further herein. Radio 10 can include a controller 25. Controller 25 can be a circuit that controls switches in reconfigurable filters included in filters 16R, filters 16T, or both filters 16R and 16T. MNs 14R and MNs 14T can be coupled to antenna switching circuit 12. Antenna switch circuit 12 may be a circuit that controls which of MNs 14R and MNs 14T is coupled to antenna 11 at any given time.

Fig. 1B is a block diagram depicting another view of radio 10 according to some embodiments. Controller 25 is omitted from Fig. 1B for clarity. As shown, radio 10 can include receiver paths 26₁...26_{N}, where N is an integer greater than zero. Receiver 10 can include transmitter paths 28₁...28_{M}, where M is an integer greater than zero. A receiver path may be circuits that receive an RF signal in a particular frequency band. A transmitter path may be circuits that transmit an RF signal in a particular frequency band. Each receiver path 26 can include an LNA 20, an MN 18R, a filter 16R, and an MN 14R (only receiver path 26₁ is shown in detail for clarity). Each transmitter path 28 can include a PA 21, MN 18T, filter 16T, and MN 14T (only transmitter path 28₁is shown in detail for clarity). The number of filters 16R, 16T, or both 16R and 16T needed, and hence the number of receiver paths 26 and transmitter paths 28, can depend on the number of frequency bands handled by radio 10. Use of reconfigurable filters can reduce the number of filters needed and hence the number of receiver paths, transmitter paths, or both needed by radio 10.

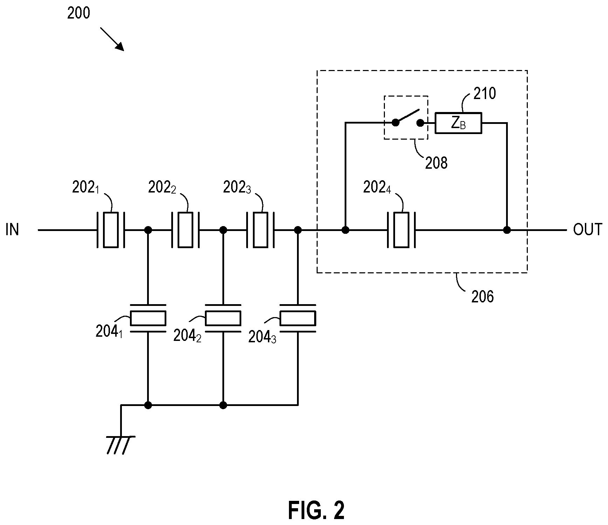

Fig. 2 is a schematic diagram depicting a reconfigurable filter 200 according to some embodiments. One or more of filters 16 can be constructed as reconfigurable filter 200. Reconfigurable filter 200 can include a plurality of resonators 202 connected in series. In the example, reconfigurable filter 200 can include resonators 202₁...202₄ connected in series. Reconfigurable filter 200 can include at least one resonator 204 connected as a shunt. In the example, reconfigurable filter 200 includes resonators 204₁...204₃ connected as shunts. In particular, a first terminal of resonator 202₁ can receive an input of reconfigurable filter 200. A second terminal of resonator 202₁ can be coupled to a first terminal of resonator 202₂. A second terminal of resonator 202₂ can be coupled to a first terminal of resonator 202₃. A second terminal of resonator 202₃ can be coupled to a first terminal of resonator 202₄. A second terminal of resonator 202₄ can supply an output of reconfigurable filter 200. A first terminal of resonator 204₁ can be coupled to the node between resonator 202₁ and 202₂. A second terminal of resonator 204₁ can be coupled to a reference voltage (e.g., electrical ground). A first terminal of resonator 204₂ can be coupled to the node between resonator 202₂ and 202₃. A second terminal of resonator 204₂ can be coupled to the reference voltage. A first terminal of resonator 204₃ can be coupled to the node between resonator 202₃ and 202₄. A second terminal of resonator 204₃ can be coupled to the reference voltage.

Reconfigurable filer 200 can include a circuit 206. Circuit 206 can include a switch 208 and an impedance 210. A switch may be a circuit that can connect or disconnect a conducting path in a circuit. Switch 208 can connect or disconnect impedance 210 from being in parallel with resonator 202₄. Impedance 210 can include a reactive impedance, such as an inductor or a capacitor or a combination thereof. A reactive impedance may be an impedance that changes with frequency. Switch 208 can be controlled by controller 25 (e.g., controller 25 can operate to open switch 208 or close switch 208).

A resonator may be a circuit or a component that exhibits resonance. That is, a resonator may oscillate with greater amplitude at some frequencies than at other frequencies. In some embodiments, resonators 202 and 204 can be free-standing bulk acoustic resonators (FBARs). An acoustic wave resonator can convert an input electrical signal to an acoustic signal and the acoustic signal to an output electrical signal. A filter formed from acoustic wave resonators can be referred to as an acoustic wave filter (AWF). An FBAR may be an acoustic wave resonator formed on a substrate that directs signal energy through the bulk of the substrate. In other embodiments, resonators 202 and 204 can be surface acoustic wave resonators. A filter formed from surface acoustic resonators can be referred to as a surface acoustic wave (SAW) filter. A surface acoustic wave resonator may be an acoustic wave resonator formed on a substrate that directs energy along the surface of the substrate. SAW resonators and FBARs and the construction thereof are known in the art. Each resonator 202, 204 can be an acoustic wave resonator, such as a SAW resonator or FBAR, or any other type of resonator known in the art.

Each resonator 202, 204 can have a resonance frequency and an anti-resonance frequency. A resonance frequency (also referred to as a resonant frequency) may be a frequency at which the resonator has minimum impedance. An anti-resonance frequency (also referred to as an anti-resonant frequency) may be a frequency at which the resonator has maximum impedance. The resonance and anti-resonance frequencies can be determined by the construction of the resonator. For example, the frequency at which an FBAR resonates can be determined by the thickness of the piezoelectric layer and the material properties.

A series resonator can allow the transmission of an RF signal having a frequency at or near the resonance frequency and can block the transmission of an RF signal having a frequency at or near the anti-resonance frequency. A shunt resonator can operate inversely to a series resonator. That is, a shunt resonator can block the transmission of an RF signal having a frequency at or near the resonance frequency and allow the transmission of an RF signal at or near the anti-resonance frequency. The combination of series and shunt resonators, e.g., resonators 202 and 204, can make a frequency band where an RF signal having a frequency within the band can pass from input (IN) to output (OUT) (referred to as a pass band) and an RF signal having a frequency outside the band is blocked from passing from input (IN) to output (OUT).

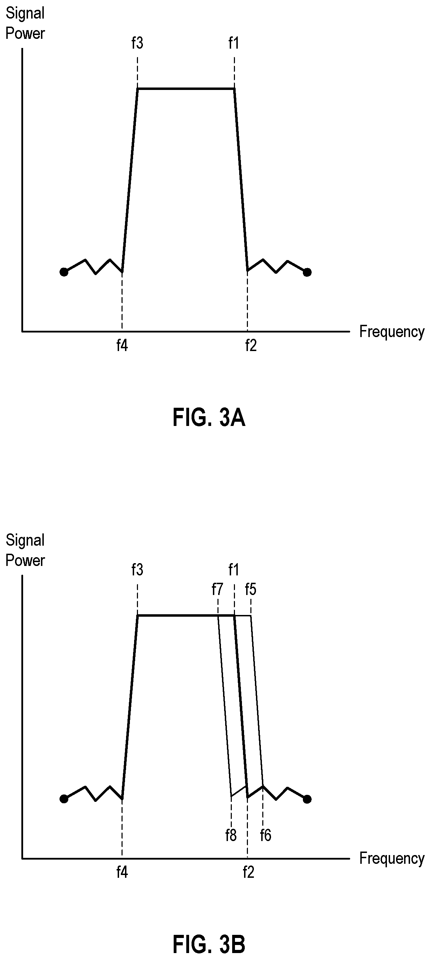

Fig. 3A is a graph depicting spectrum characteristics of reconfigurable filter 200 without circuit 206 or with switch 208 in circuit 206 being set to open. The Y-axis of the graph represents signal power and the X-axis of the graph represents frequency. The f1-f2 slope of the curve may be a right-side boundary between pass and block frequency. The f3-f4 slope of the curve may be a left-side boundary between pass and block frequency. An RF signal with frequency between f3 and f1 can be within the pass band of the filter. An RF signal with a frequency less than f4 or greater than f2 can be outside the pass band of the filter. The spectrum characteristics shown in Fig. 3A are fixed since the frequencies f1, f2, f3, and f4 are properties of resonators 202, 204 as constructed.

Fig. 3B is a graph depicting spectrum characteristics of reconfigurable filter 200 with switch 208 in circuit 206 being set to closed. As shown in Fig. 3B, the f1-f2 slope can be the spectrum characteristic where switch 208 is set to open (as shown in Fig. 3A). When switch 208 is set to closed, the spectrum characteristics can be changed in that the slope of the right-side boundary between pass and block frequency can be moved to either expand the pass band or contract the pass band. The pass band can be expanded if impedance 210 is an inductor, i.e., the f5-f6 slope of the curve may become the right-side boundary. The pass band can be contracted if impedance 210 is a capacitor, i.e., the f7-f8 slope of the curve may become the right-side boundary.

Returning to Fig. 2, the location of circuit 206 can vary. That is, circuit 206 can be coupled across the terminals of any of resonators 202₁...202₄. In some embodiments, reconfigurable filter 200 can include more than one instance of circuit 206. For example, another instance of circuit 206 can be coupled across the terminals of any of resonators 202₁...202₃. In cases of multiple instances of circuit 206, switches 208 can be controlled individually (e.g., one on, the other on, both on) or concurrently (e.g., both on or both off). In cases of multiple instances of circuit 206, a first instance can have impedance 210 as an inductor and a second instance can have impedance 210 as a capacitor. In cases of multiple instances of circuit 206, impedance 210 of both first and second instances can be an inductor or a capacitor. By controlling a switch or switches of reconfigurable filter 200, the pass band of the filter can be varied. Use of reconfigurable filter in radio 10 can reduce the number of filters needed.

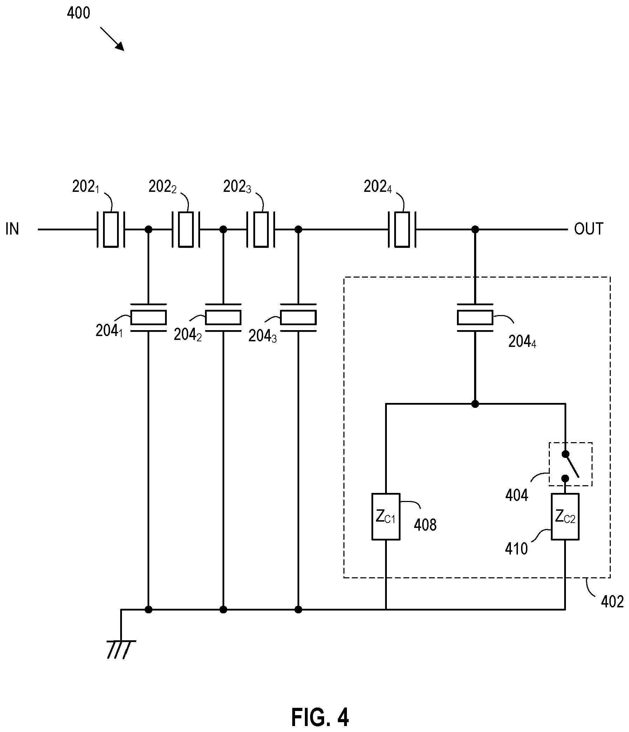

Fig. 4 is a schematic diagram depicting a reconfigurable filter 400 according to some embodiments. One or more of filters 16 can be constructed as reconfigurable filter 400. Reconfigurable filter 400 can include resonators 202 and 204 as shown in Fig. 2 and described above. However, in reconfigurable filter 400, circuit 206 is not present. Rather, reconfigurable filter 400 includes a circuit 402. Circuit 402 includes a resonator 204₄, an impedance 408, a switch 404, and an impedance 410. Resonator 204₄ may be another one of the shunt resonators described above. A first terminal of resonator 204₄ can be coupled to the second terminal of resonator 202₄, i.e., the output (OUT). Impedance 408 can be coupled between a second terminal of resonator 204₄ and the reference voltage (e.g., electrical ground). A series combination of switch 404 and impedance 410 can be coupled between the second terminal of resonator 204₄ and the reference voltage. Switch 404 can be controlled by controller 25. The spectrum characteristics of reconfigurable filter 400 without circuit 402 or when switch 404 is open can be the same or similar to that shown in Fig. 3A. Impedance 410 can include a reactive impedance, such as an inductor or a capacitor or a combination thereof. Impedance 408 can be an inductor.

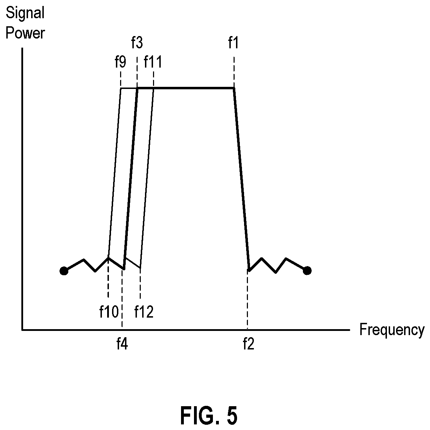

Fig. 5 is a graph depicting spectrum characteristics of reconfigurable filter 400 with switch 404 in circuit 402 being set to closed. As shown in Fig. 5, the f3-f4 slope can be the spectrum characteristic where switch 404 is set to open. When switch 404 is set to closed, the spectrum characteristics can be changed in that the slope of the left-side boundary between pass and block frequency can be moved to either expand the pass band or contract the pass band. The pass band can be expanded if impedance 410 is a capacitor, i.e., the f9-f10 slope of the curve may become the left-side boundary. The pass band can be contracted if impedance 410 is an inductor, i.e., the f11-f12 slope of the curve may become the left-side boundary.

Returning to Fig. 4, the location of circuit 406 can vary. That is, circuit 406 can be coupled between any of resonators 204₁...204₄ and the reference voltage. In some embodiments, reconfigurable filter 400 can include more than one instance of circuit 402. For example, another instance of circuit 402 can be coupled between any of resonators 204₁...204₃ and the reference voltage. In cases of multiple instances of circuit 402, switches 404 can be controlled individually (e.g., one on, the other on, both on) or concurrently (e.g., both on or both off). In cases of multiple instances of circuit 406, a first instance can have impedance 410 as an inductor and a second instance can have impedance 410 as a capacitor. In cases of multiple instances of circuit 402, impedance 410 of both first and second instances can be an inductor or a capacitor. By controlling a switch or switches of reconfigurable filter 400, the pass band of the filter can be varied. Use of reconfigurable filter in radio 10 can reduce the number of filters needed.

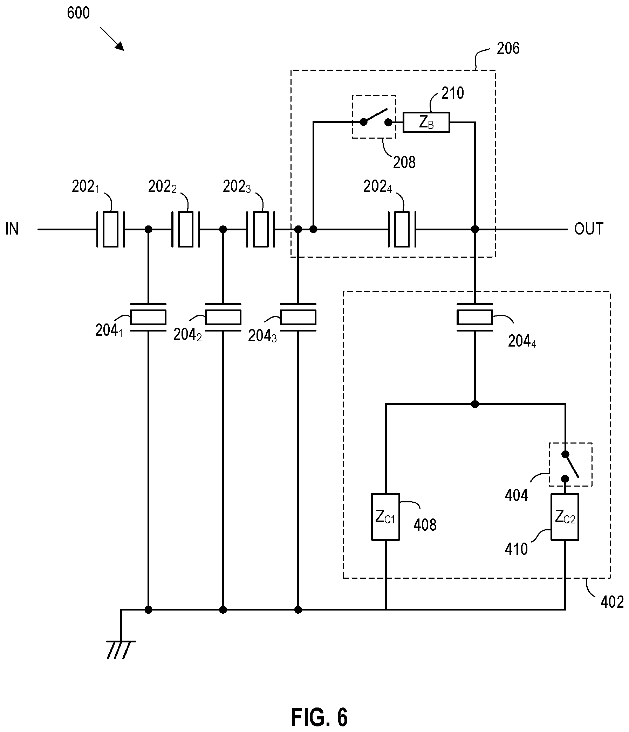

Fig. 6 is a schematic diagram depicting a reconfigurable filter 600 according to some embodiments. One or more of filters 16 can be constructed as reconfigurable filter 600. In some embodiments, reconfigurable filter 600 can include both an instance of circuit 206 and an instance of circuit 402. In this manner, switches 208 and 404 can be controlled to move either or both of the left-side boundary and the right-side boundary of the spectrum. Thus, the passband can be contracted, expanded, shifted left, or shifted right, by controlling switches 208 and 404 and by selecting the type of reactive impedance for impedances 210, 410. Similar to reconfigurable filters 200 and 400, reconfigurable filter 600 can vary position of circuit 206, circuit 402, or both. Similar to reconfigurable filters 200 and 400, reconfigurable filter 600 can include multiple instances of circuit 206, multiple instances of circuit 402, or both multiple instances of circuit 206 and 402.

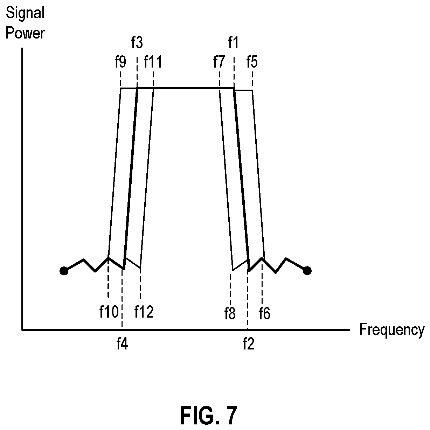

Fig. 7 is a graph depicting spectrum characteristics of reconfigurable filter 600 with switch 404 in circuit 402 being set to closed and switch 208 in circuit 206 being closed. As shown in Fig. 7, the f1-f2 slope can be the spectrum characteristic where switch 208 is set to open (as shown in Fig. 3A). When switch 208 is set to closed, the spectrum characteristics can be changed in that the slope of the right-side boundary between pass and block frequency can be moved to either expand the pass band or contract the pass band. The pass band can be expanded if impedance 210 is an inductor, i.e., the f5-f6 slope of the curve may become the right-side boundary. The pass band can be contracted if impedance 210 is a capacitor, i.e., the f7-f8 slope of the curve may become the right-side boundary. The f3-f4 slope can be the spectrum characteristic where switch 404 is set to open. When switch 404 is set to closed, the spectrum characteristics can be changed in that the slope of the left-side boundary between pass and block frequency can be moved to either expand the pass band or contract the pass band. The pass band can be expanded if impedance 410 is a capacitor, i.e., the f9-f10 slope of the curve may become the left-side boundary. The pass band can be contracted if impedance 410 is an inductor, i.e., the f11-f12 slope of the curve may become the left-side boundary.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" and its derivatives include: (a) electrical and communicative coupling; and (b) do not imply a direct connection, but rather may include intervening elements, unless described as "directly coupled."

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

The invention further provides the following embodiments:
1. A filter for radio frequency (RF) signals, comprising:
   first resonators coupled in series between an input and an output;
   a second resonator coupled as a shunt between a node in the series and a reference voltage; and
   a first circuit coupled in parallel with one of the first resonators, the first circuit including a switch coupled in series with an impedance.
2. The filter of embodiment 1, wherein the impedance of the first circuit is a reactive impedance.
3. The filter of embodiment 1, wherein the switch is a first switch and the impedance is a first impedance, and wherein the filter further comprises:
   a second circuit coupled in parallel with another one of the first resonators, the second circuit including a second switch coupled in series with a second impedance.
4. The filter of embodiment 1, the switch is a first switch and the impedance is a first impedance, and wherein the filter further comprises:
   a second circuit coupled between the second resonator and the reference voltage, the second circuit including a second impedance in parallel with a series combination of a third impedance and a second switch.
5. The filter of embodiment 4, wherein the third impedance of the second circuit is a reactive impedance.
6. The filter of embodiment 1, wherein the first resonators and the second resonator comprise acoustic wave resonators.
7. The filter of embodiment 5, wherein the first resonators and the second resonator comprise free-standing bulk acoustic resonators (FBARs) or surface acoustic wave (SAW) resonators.
8. A filter for radio frequency (RF) signals, comprising:
   first resonators coupled in series between an input and an output;
   a second resonator coupled as a shunt between a node in the series and a reference voltage; and
   a first circuit coupled between the second resonator and the reference voltage, the first circuit including a first impedance in parallel with a series combination of a second impedance and a switch.
9. The filter of embodiment 8, wherein the second impedance of the first circuit is a reactive impedance.
10. The filter of embodiment 8, wherein the switch is a first switch, and wherein the filter further comprises:
   a third resonator coupled as another shunt between another node in the series and the reference voltage; and
   a second circuit coupled between the third resonator and the reference voltage, the second circuit including a third impedance in parallel with a series combination of a fourth impedance and a second switch.
11. The filter of embodiment 8, the switch is a first switch, and wherein the filter further comprises:
   a second circuit coupled in parallel with one of the first resonators, the second circuit including a second switch coupled in series with a third impedance.
12. The filter of embodiment 11, wherein the third impedance of the second circuit is a reactive impedance.
13. The filter of embodiment 8, wherein the first resonators and the second resonator comprise acoustic wave resonators.
14. The filter of embodiment 13, wherein the first resonators and the second resonator comprise free-standing bulk acoustic resonators (FBARs) or surface acoustic wave (SAW) resonators.
15. An apparatus, comprising:
   an antenna;
   a receiver path and a transmitter path coupled to the antenna;
   a filter disposed in the receiver path or the transmitter path, the filter comprising:
      first resonators coupled in series between an input and an output;
      a second resonator coupled as a shunt between a node in the series and a reference voltage; and
      at least one of: (1) a first circuit coupled in parallel with one of the first resonators, the first circuit including a first switch coupled in series with first impedance; and (2) a second circuit coupled between the second resonator and the reference voltage, the second circuit including a second impedance in parallel with a series combination of a third impedance and a second switch.
16. The apparatus of embodiment 15, wherein the first impedance of the first circuit and the third impedance of the second circuit are reactive impedances.
17. The apparatus of embodiment 15, wherein the radio includes both the first circuit and the second circuit.
18. The apparatus of embodiment 15, further comprising a third circuit coupled in parallel with another one of the first resonators, the third circuit including a third switch coupled in series with a fourth impedance.
19. The apparatus of embodiment 15, further comprising:
   a third resonator coupled as another shunt between another node in the series and the reference voltage; and
   a third circuit coupled between the third resonator and the reference voltage, the third circuit including a fourth impedance in parallel with a series combination of a fifth impedance and a third switch.
20. The apparatus of embodiment 15, wherein the first resonators and the second resonator comprise free-standing bulk acoustic resonators (FBARs) or surface acoustic wave (SAW) resonators.

## Claims

1. A filter for radio frequency (RF) signals, comprising:
first resonators coupled in series between an input and an output;
a second resonator coupled as a shunt between a node in the series and a reference voltage; and
a first circuit coupled in parallel with one of the first resonators, the first circuit including a switch coupled in series with an impedance.

2. The filter of claim 1, wherein the impedance of the first circuit is a reactive impedance.

3. The filter of claim 1 or claim 2, wherein the switch is a first switch and the impedance is a first impedance, and wherein the filter further comprises:
a second circuit coupled in parallel with another one of the first resonators, the second circuit including a second switch coupled in series with a second impedance; and/or
a second circuit coupled between the second resonator and the reference voltage, the second circuit including a second impedance in parallel with a series combination of a third impedance and a second switch, in particular wherein the third impedance of the second circuit is a reactive impedance.

4. The filter of any of claims 1 to 3, wherein the first resonators and the second resonator comprise acoustic wave resonators, in particular wherein the first resonators and the second resonator comprise free-standing bulk acoustic resonators (FBARs) or surface acoustic wave (SAW) resonators.

5. A filter for radio frequency (RF) signals, comprising:
first resonators coupled in series between an input and an output;
a second resonator coupled as a shunt between a node in the series and a reference voltage; and
a first circuit coupled between the second resonator and the reference voltage, the first circuit including a first impedance in parallel with a series combination of a second impedance and a switch.

6. The filter of claim 5, wherein the second impedance of the first circuit is a reactive impedance.

7. The filter of claim 5 or claim 6, wherein the switch is a first switch, and wherein the filter further comprises:
a third resonator coupled as another shunt between another node in the series and the reference voltage; and
a second circuit coupled between the third resonator and the reference voltage, the second circuit including a third impedance in parallel with a series combination of a fourth impedance and a second switch.

8. The filter of any of claims 5 to 7, the switch is a first switch, and wherein the filter further comprises:
a second circuit coupled in parallel with one of the first resonators, the second circuit including a second switch coupled in series with a third impedance, in particular wherein the third impedance of the second circuit is a reactive impedance.

9. The filter of any of claims 5 to 8, wherein the first resonators and the second resonator comprise acoustic wave resonators, in particular wherein the first resonators and the second resonator comprise free-standing bulk acoustic resonators (FBARs) or surface acoustic wave (SAW) resonators.

10. An apparatus, comprising:
an antenna;
a receiver path and a transmitter path coupled to the antenna;
a filter disposed in the receiver path or the transmitter path, the filter comprising:
first resonators coupled in series between an input and an output;
a second resonator coupled as a shunt between a node in the series and a reference voltage; and
at least one of: (1) a first circuit coupled in parallel with one of the first resonators, the first circuit including a first switch coupled in series with first impedance; and (2) a second circuit coupled between the second resonator and the reference voltage, the second circuit including a second impedance in parallel with a series combination of a third impedance and a second switch.

11. The apparatus of claim 10, wherein the first impedance of the first circuit and the third impedance of the second circuit are reactive impedances.

12. The apparatus of claim 10 or claim 11, wherein the radio includes both the first circuit and the second circuit.

13. The apparatus of any of claims 10 to 12, further comprising a third circuit coupled in parallel with another one of the first resonators, the third circuit including a third switch coupled in series with a fourth impedance.

14. The apparatus of any of claims 10 to 13, further comprising:
a third resonator coupled as another shunt between another node in the series and the reference voltage; and
a third circuit coupled between the third resonator and the reference voltage, the third circuit including a fourth impedance in parallel with a series combination of a fifth impedance and a third switch.

15. The apparatus of any of claims 10 to 14, wherein the first resonators and the second resonator comprise free-standing bulk acoustic resonators (FBARs) or surface acoustic wave (SAW) resonators.
